Europäisches Patentamt

(19) European Patent Office

Office européen des brevets

(11) Veröffentlichungsnummer: **0 294 325**
**A2**

(12) # EUROPÄISCHE PATENTANMELDUNG

(21) Anmeldenummer: 88810322.3

(22) Anmeldetag: 20.05.88

(51) Int. Cl.⁴: **H 05 K 3/06**
H 05 K 3/34
// G03F7/00

(30) Priorität: 30.05.87 GB 8712731

(43) Veröffentlichungstag der Anmeldung:
**07.12.88 Patentblatt 88/49**

(84) Benannte Vertragsstaaten:
**BE CH DE ES FR GB IT LI NL SE**

(71) Anmelder: **CIBA-GEIGY AG**
**Klybeckstrasse 141**
**CH-4002 Basel (CH)**

(72) Erfinder: **Demmer, Christopher George, Dr.**
**8 Southfield Ickleton**
**Saffron Walden Essex CB10 1TE (GB)**

**Irving, Edward, Dr.**
**41 Swaffham Road**
**Burwell Cambridge CB5 OAN (GB)**

**Banks, Christopher Paul, Dr.**
**105 Ross Close**
**Saffron Walden Essex CB11 4 DU (GB)**

(54) **Verfahren zur Herstellung von metallischen Mustern.**

(57) Beschrieben wird ein Verfahren zur Herstellung von metallischen Mustern, wobei ein Substrat eingesetzt wird, dass auf einer Oberfläche ein in vorbestimmten Mustern freiliegendes Metall und in den restlichen Flächen ein mit einem ersten Resist bedecktes Metall aufweist. Das Verfahren umfasst die Schritte

i) Schutz des freiliegenden Metalls durch galvanisches Abscheiden eines Harzfilms auf besagtem Metall,

ii) Entfernen des ersten Resists von besagten Flächenanteilen durch Verwendung eines Lösungsmittels, welches den galvanisch abgeschiedenen Film nicht entfernt,

iii) Aetzen des in Schritt ii) freigelegten Metalls unter Verwendung eines Aetzmittels, das den galvanisch abgeschiedenen Film nicht entfernt,

iv) Herstellen einer Schicht eines zweiten Resists in einem vorbestimmten Muster über dem galvanisch abgeschiedenen Film, wobei Flächenanteile besagten galvanisch abgeschiedenen Films durch besagten Resist nicht bedeckt werden, und

v) Entfernen der unbedeckten Flächenanteile des galvanisch abgeschiedenen Films durch Behandlung mit einem Lösungsmittel dafür.

Mit dem Verfahren lassen sich gedruckte Schaltungen herstellen.

**Beschreibung**

## Verfahren zur Herstellung von metallischen Mustern

Die vorliegende Erfindung betrifft die Herstellung metallischer Muster, beispielsweise die Herstellung gedruckter Schaltungen.

Es gibt zahlreiche Methoden zur Herstellung von gedruckten Schaltungen, obgleich einige der verwendeten Verfahrensschritte allen diesen Methoden gemeinsam sind.

Im Falle der einseitig gedruckten Schaltungen wird ein Resist auf das Kupfer eines kupfer-kaschierten Kunststofflaminats, das gegebenenfalls Bohrungen aufweise, in einem vorbestimmten Muster aufgebracht, wobei Siebdruck oder Photoabbildungsverfahren eingesetzt werden. Auf diese Weise erhält man eine Platte, die an einigen Stellen freies Kupfer aufweist und worin an den restlichen Stellen das Kupfer mit dem Resist bedeckt ist. Das frei zugängliche Kupfer wird anschliessend galvanisch mit einer Zinn-Blei Legierung überzogen, der Resist wird entfernt und das dadurch freigelegte Kupfer wird dann mit einem geeigneten Aetzmittel weggeätzt, welches die Zinn-Blei Legierung nicht entfernt. Schliesslich wird die Zinn-Blei Legierung mit einem Entmetallisierbad für Zinn-Blei Legierungen (tin-lead alloy stripper) entfernt.

Im Falle der doppelseitigen gedruckten Schaltungen mit galvanisch überzogenen durchgehenden Oeffnungen verwendet man ein ähnliches Herstellungsverfahren, das aber folgende zusätzliche Schritte aufweist:

Nach dem Aufbohren der Oeffnungen wird die Platte einer stromlosen Verkupferung unterzogen, um auf der Oberfläche der Oeffnungen (sowie auf der Kupferoberfläche Kupfer abzuscheiden.

Nachdem der Resist in einem vorbestimmten Muster auf die Platte aufgebracht wurde, wird die Platte galvanisch verkupfert, wobei Kupfer auf den freiliegenden Teilen der Kupferoberfläche sowie auf der Oberfläche der Oeffnungen abgeschieden wird. Die Kupfermuster, die durch diese an sich bekannten Verfahren erhalten werden, behandelt man in der Regel weiter; dadurch werden vorbestimmte Flächen dieser Muster für ein Lötmittel zugänglich gemacht, wobei Komponenten, wie Widerstände oder Kondensatoren, mit dem elektrischen Schaltkreis verbunden werden können, und die anderen vorbestimmten Flächen dieser Muster werden einer solchen Behandlung unzugänglich gemacht.

Dies erreicht man in der Regel durch Herstellung einer Schicht einer Lötstoppmaske auf besagtem Kupfermuster; dabei kann es sich um einen strahlungs- oder hitzegehärteten Harzfilm handeln, der sich auf vorbestimmten Flächenanteilen auf besagtem Kupfermuster befindet, wobei Teile des Musters frei zugänglich bleiben und für die Verbindung mit den verschiedenen Komponenten zur Verfügung stehen.

Mit diesem zusätzlichen Verfahrensschritt wird also im Prinzip ein weiteres Kupfermuster hergestellt, wobei vorbestimmte Teile des ursprünglich erhaltenen Musters verdeckt werden.

Nachteile der bekannten Verfahren sind die hohen Kosten des Entmetallisierbades für Zinn-Blei Legierungen und der notwendige folgende Reinigungsschritt; ferner greift das Entmetallisierbad für Zinn-Blei Legierungen (üblicherweise eine Mischung aus Wasserstoffperoxid und Schwefelsäure) die Platten, das Bedienungspersonal und die Ausrüstung für den Entmetallisierprozess an.

Es wurde nun gefunden, dass das nach dem Aufbringen des Resists freigebliebene Kupfer durch Abscheidung eines galvanisch abscheidbaren Harzes geschützt werden kann, wobei besagtes Harz durch den Aetzschritt nicht entfernt wird und auch während der folgenden Verfahrensschritte zur Herstellung des gewünschten Metallmusters auf dem Kupfer verbleiben kann.

Galvanisch abscheidbare Harze sind seit Jahren bekannt und werden in der Regel zum Beschichten von Metallgegenständen, beispielsweise zum Lackieren von Automobilkarrosserien oder -zubehör, Stahlträgern oder Haushaltsgeräten, wie Waschmaschinen, eingesetzt.

Bei diesen Anwendungen werden die Harze galvanisch abgeschieden und anschliessend gehärtet.

In der SU-A-293,312 wird vorgeschlagen, ein galvanisch abscheidbares Harz zum Schutz des Kupfers bei der Herstellung von Leiterplatten einzusetzen. Nach der galvanischen Abscheidung wird das Harz thermisch gehärtet. Das gehärtete Harz wird schliesslich durch Behandlung mit einer stark alkalischen Lösung bei 70 bis 80°C entfernt. Dies sind harte Bedingungen, unter denen das Basislaminat der Leiterplatte beschädigt werden kann.

Es wurde gefunden, dass das galvanisch abgeschiedene Harz an Ort und Stelle verbleiben kann, während die Leiterplatte mit einem weiteren Resist, wie einer Lötstoppmaske, in einem vorbestimmten Muster beschichtet wird. Besagte Beschichtung wird auch in herkömmlichen Verfahren, wie oben beschrieben, verwendet, um diejenigen Teile des Metallmusters zu schützen, die nicht mit anderen Komponenten verlötet werden sollen.

Dann wird das galvanisch abgeschiedene Harz nur an denjenigen Stellen entfernt, an denen freies Kupfer benötigt wird, um durch die folgende Anwendung von Lötmittel eine Verbindung von Komponenten mit der gedruckten Schaltung zu gewährleisten.

Durch das erfindungsgemässe Verfahren entfällt also die Notwendigkeit, das gesamte galvanisch abgeschiedene Harz zu entfernen. Handelt es sich bei der Lötstoppmaske um ein strahlungsempfindliches Material, welches durch ein Abbildungsverfahren als vorbestimmtes Muster auf die Leiterplatte aufgebracht wird, so kann das galvanisch abgeschiedene Harz durch Behandlung mit dem bei der Entwicklung der Abbildung verwendeten Lösungsmittel von den gewünschten Teilen der Fläche entfernt werden. Dabei entfällt die Notwendigkeit eines separaten Verfahrensschrittes, mit dem das galvanisch abgeschiedene Harz entfernt wird.

Ferner vermittelt das galvanisch abgeschiedene Harz, welches unter der Lötstoppmaske verbleibt, eine gute Haftung zwischen unten liegendem Kupfer und der Lötstoppmaske.

Die vorliegende Erfindung betrifft ein Verfahren zur Herstellung von metallischen Mustern auf einem Substrat, welches auf der Oberfläche in vorbestimmten Flächen freiliegendes Metall aufweist und in den restlichen Flächen mit einem ersten Resist bedecktes Metall aufweist, umfassend die Schritte

i) Schutz des freiliegenden Metalls durch galvanisches Abscheiden eines Harzfilms auf besagtem Metall,

ii) Entfernen des ersten Resists von besagten restlichen Flächen unter Verwendung eines Lösungsmittels, das den galvanisch abgeschiedenen Film nicht entfernt,

iii) Aetzen des in Schritt ii) freigelegten Metalls mit einem Aetzmittel, das besagten galvanisch abgeschiedenen Film nicht entfernt,

iv) Herstellen einer Schicht eines zweiten Resists in einem vorbestimmten Muster über besagtem galvanisch abgeschiedenen Film, wobei Flächen des galvanisch abgeschiedenen Films von dem Resist nicht bedeckt werden, und

v) Entfernen der unbedeckten Teile besagten galvanisch abgeschiedenen Films durch Behandlung mit einem Lösungsmittel für besagten Film.

Der als Beschichtung des Ausgangssubstrates verwendete Resist kann ein Epoxidharz sein, das vermittels eines Siebdruckverfahrens aufgebracht und anschliessend gehärtet wird.

Vorzugsweise handelt es sich bei einem solchen Resist um einen Photolack, der ausgewählte Flächen bedeckt, der einheitlich auf das Substrat, welches in der Regel ein kupferkaschiertes Laminat ist, aufgebracht wird, in einem vorbestimmten Muster mit aktinischer Strahlung bestrahlt wird und von dem dann die belichteten oder die nicht belichteten Stellen entfernt werden, je nachdem, ob ein positiv- oder negativ-arbeitender Photolack eingesetzt wurde.

Positiv- und negativ-arbeitende Photolacke zur Herstellung von gedruckten Schaltungen sind wohlbekannt und man kann praktisch jedes dieser Materialien verwenden.

Diese Lacke können durch Behandlung mit wässrigen Entwicklern oder mit organischen Lösungsmitteln entfernt werden.

Vor der Galvanisierstufe i) kann eine Schicht eines weiteren Metalls, beispielsweise Nickel, auf dem freiliegenden Kupfer abgeschieden werden. Bei dem in Schritt i) abzuscheidenden Harzfilm kann irgendein galvanisch abscheidbares Harz eingesetzt werden, welches anodisch oder kathodisch abscheidbar ist.

Falls saure Aetzmittel verwendet werden sollen, sind anodisch abscheidbare Harze bevorzugt; kathodisch abscheidbare Harze sind bevorzugt, wenn basische Aetzmittel eingesetzt werden sollen.

Eine besonders bevorzugte Kombination betrifft die Verwendung eines Photoresists, der in Schritt ii) unter wässrigen Bedingungen entfernbar ist und die Verwendung eines galvanisch abscheidbaren Harzes, das in Schritt v) durch Behandlung mit einem organischen Lösungsmittel entfernbar ist.

Jedes Harz aus der grossen Anzahl galvanisch abscheidbarer Harze kann verwendet werden. Dazu zählen beispielsweise Acrylharze; Addukte von Epoxidharzen mit Aminen, Polycarbonsäuren oder deren Anhydriden, Aminocarbonsäuren, Mercaptocarbonsäuren oder Aminosulfonsäuren; Polyurethane; Polyester; sowie Umsetzungsprodukte von Harzen enthaltend phenolische Hydroxylgruppen mit Aldehyden und Aminen oder Amino- oder Mercaptocarbonsäuren oder Aminosulfonsäuren.

Geeignete Acrylharze umfassen Copolymere von wenigstens einem Acrylester, wie zum Beispiel einem Alkyl- oder Hydroxyalkylacrylat oder -methacrylat, mit einem ethylenisch ungesättigten Monomeren enthaltend eine salzbildende Gruppe, wie beispielsweise mit einem Acrylmonomeren enthaltend eine Carboxyl- oder tert.Aminogruppe, und gegebenenfalls mit einem weiteren ethylenisch ungesättigten Monomeren.

Geeignete Epoxidharzaddukte umfassen Addukte von Diglycidylethern zweiwertiger Alkohole oder von Bisphenolen mit einem primären oder sekundären Amin, in der Regel einem Monoamin, wie beispielsweise Ethanolamin, 1-Amino-2-propanol, Diethanolamin oder Diethylamin, oder mit einer Polycarbonsäure, wie Glutarsäure oder Adipinsäure, oder mit einem Anhydrid einer Polycarbonsäure, wie Maleinsäure- oder Bernsteinsäureanhydrid, oder mit einer Aminocarbonsäure, wie o-, m- oder p-Aminobenzoesäure, oder mit einer Mercaptocarbonsäure.

Geeignete Polyurethane umfassen Addukte von hydroxyl-terminierten Polyurethanen mit Polycarbonsäureanhydriden.

Geeignete Polyester umfassen carboxyl-terminierte Polyester, die sich von mehrwertigen Alkoholen, wie zum Beispiel von Ethylenglykol, 1,2-Propylenglykol, 1,3-Propylenglykol oder 1,4-Butandiol, und von Polycarbonsäuren, wie zum Beispiel von Glutar-, Adipin-, Malein-, Tetrahydrophthalsäure oder Phthalsäuren sowie von deren esterbildenden Derivaten, ableiten.

Geeignete Umsetzungsprodukte von Harzen enthaltend phenolische Hydroxylgruppen umfassen Reaktionsprodukte von phenol-terminierten Addukten von Diglycidylethern mit Bisphenolen, mit Aldehyden, wie beispielsweise Formaldehyd oder Benzaldehyd, und Aminen, wie beispielsweise Ethanolamin, Diethanolamin oder Ethylendiamin, Aminocarbonsäuren, wie beispielsweise Glycin, Sarkosin oder Asparaginsäure, oder Mercaptocarbonsäuren, wie beispielsweise Thioglykolsäure oder 3-Mercaptopropionsäure.

Bevorzugte galvanisch abscheidbare Harze sind Copolymere auf Basis wenigstens eines Monoacrylesters, insbesondere ausgewählt aus der Gruppe bestehend aus Methylacrylat, Ethylacrylat, 2-Hydroxyethylacrylat, 2-Hydroxypropylacrylat, Butylacrylat, Ethylhexylacrylat und den entsprechenden Methacrylaten, mit wenigstens einem Monoacrylmonomer enthaltend eine Carboxyl- oder tert.Aminogruppe, insbesondere Acrylsäure, Methacrylsäure oder Dimethylaminoethylmethacrylat, und gegebenenfalls mit einem weiteren Vinylmonomer, beispielsweise mit Styrol.

Weitere bevorzugte galvanisch abscheidbare Harze sind Addukte von einem Diglycidylether auf Basis eines Bisphenols, insbesondere auf Basis von Bisphenol A, welche gegebenenfalls vorverlängert sein können, mit einem Monoamin, insbesondere Diethanolamin.

Die galvanische Abscheidung des Harzfilms kann mit konventionellen Verfahren für solche Harze erfolgen. Dazu kann das galvanisch abscheidbare Harz, gegebenenfalls zusammen mit einem hitzeaktivierbaren Härtungsmittel und weiteren üblichen Zusätzen, wie Pigmenten, Farbstoffen, Füllstoffen oder Weichmachern, in einem wässrigen Medium gelöst oder dispergiert werden, das gegebenenfalls einen kleineren Anteil an einem organischen Lösungsmittel enthalten kann zusammen mit einer Säure oder einer Base, die zumindest ein Teil der salzbildenden Gruppen des Harzes neutralisiert. Der Harzanteil des wässrigen Galvanisierbades beträgt in der Regel 2-60 Gew.%, vorzugsweise 5-25 Gew.%.

Die Menge des galvanisch abgeschiedenen Films muss ausreichen, um das freiliegende Metall vollständig zu bedecken, um dieses beim Entfernen des ersten Resists und während des Aetzens des dadurch greigelegten Metalls zu schützen.

In der Regel genügt es für diesen Zweck, die galvanische Abscheidung von einigen Minuten Dauer, üblicherweise von einer Minute Dauer, bei Spannungen von bis zu 200 V durchzuführen.

In einigen Fällen können Galvanisierspannungen bis hinunter zu 2 V angelegt werden; dies ist insbesondere dann der Fall, wenn die Abmessungen der zu beschichtenden Elektrode klein gegenüber der anderen Elektrode sind.

So lässt sich beispielsweise ein kathodisch abscheidbares Harz in einem Behälter auf einer kleinen Kathode abscheiden, wobei der Behälter als Anode geschaltet ist. Dabei können Spannungen von 2 V oder 5 V angelegt werden.

Es wurde ferner gefunden, dass die Haftung des galvanisch abgeschiedenen Films verbessert werden kann, wenn das Harz in zwei Stufen abgeschieden wird; zunächst bei einer niedrigen Spannung und anschliessend bei einer höheren Spannung. So lässt sich beispielsweise eine gute Beschichtung erhalten, indem man das Harz zunächst zwei Minuten lang bei 2 V abscheidet und anschliessend die Abscheidung fünf Minuten lang bei 5 V fortsetzt.

Der Resist in Schritt ii) kann durch Behandlung mit einem wässrigen Lösungsmittel entfernt werden.

Man kann auch eine Kombination eines Photoresists und eines galvanisch abscheidbaren Harzes verwenden, die beide unter sauer-wässrigen Bedingungen oder unter basisch-wässrigen Bedingungen entfernbar sind, mit der Massgabe, dass der Photoresist unter milderen Bedingungen entfernt werden kann, als zur Entfernung des galvanisch abgeschiedenen Harzes nötig sind, beispielsweise durch Anwendung einer stärker verdünnten Lösung einer Säure oder einer Base.

Verwendet man zur Entfernung des Resists in Schritt ii) ein organisches Lösungsmittel, so kann ein geeignetes Lösungsmittel, welches das galvanisch abgeschiedene Harz nicht auflöst, durch Routinetests gefunden werden. Sowohl dieses Lösungsmittel als auch das in Schritt v) zur Entfernung des galvanisch abgeschiedenen Harzes eingesetzte Lösungsmittel kann ausgewählt werden aus der Gruppe bestehend aus Kohlenwasserstoffen, wie Toluol und Xylol; halogenierten Kohlenwasserstoffen, wie 1,1,1-Trichlorethan und Dichlormethan; hydroxylgruppenhaltigen Lösungsmitteln, wie 2-n-Butoxyethanol, 2-Ethoxyethanol und Diethylenglykolmonobutylether; Estern, wie 2-Ethoxyethylacetat, Propylencarbonat und Butyrolacton; Ketonen, wie Aceton, Methylethylketon und Cyclohexanon; und Ethern, wie Tetrahydrofuran.

Ist das galvanisch abgeschiedene Harz beispielsweise von einem Epoxidharz abgeleitet und der Resist ist ein Acrylatmaterial, so kann man den Resist in Schritt ii) durch Verwendung eines Halogenkohlenwasserstoff-Lösungsmittels entfernen und das galvanisch abgeschiedene Harz kann in Schritt v) durch Verwendung eines Ketons entfernt werden.

Vor Ausführung des Aetzschrittes iii), und ganz besonders vor Entfernen des Resists in Schritt ii), wird das galvanisch abgeschiedene Harz vorzugsweise getrocknet, beispielsweise durch Erhitzen auf eine Temperatur von bis zu 110°C.

Das durch Entfernen des Resists freigelegte Metall, in der Regel handelt es sich dabei um Kupfer, kann in Schritt iii) des erfindungsgemässen Verfahrens durch Behandlung mit einem an sich bekannten Aetzmittel entfernt werden. Beispiele für Aetzmittel sind Eisen-III-chlorid, Wasserstoffperoxid/ Phosphorsäure, Ammoniumpersulfat oder Kupfer-II-chlorid.

Nach Beendigung von Schritt iii) besitzt die Substratoberfläche vorbestimmte Flächen von Metall, das mit galvanisch abgeschiedenem Harz bedeckt ist, und vorbestimmte Flächen, von denen das Metall durch den Aetzprozess entfernt worden ist.

Handelt es sich bei dem ursprünglichen Substrat um ein kupferkaschiertes Kunststofflaminat, so besteht die Oberfläche am Ende von Schritt iii) aus vorbestimmten Flächen von Kupfer, das mit dem galvanisch abgeschiedenen Harz bedeckt ist und aus Flächen, an denen das Basislaminat kein Kupfer aufweist.

Nach dem Aetzschritt wird über dem galvanisch abgeschiedenen Harz und in der Regel auch über den in Schritt iii) geätzten Flächenanteilen ein vorbestimmtes Muster einer Resistschicht erzeugt, das beispielswiese als Lötstoppmaske dient. Es sei hier darauf hingewiesen, dass in den Flächen, die in Schritt iii) vom Metall befreit wurden, die Anwesenheit einer Lötstoppmaske nicht unbedingt erforderlich ist. Jedoch ist es in der Praxis in der Regel zweckdienlicher, auch in diesen Flächen eine Lötstoppmaske vorliegen zu haben.

Die Erzeugung eines Musters in Schritt iv) kann durch direktes Aufbringen einer härtbaren, vorzugsweise einer photohärtbaren, Harzmischung in einem vorbestimmten Muster mittels eines Siebdruckverfahrens erfolgen und durch nachfolgende Härtung der Zusammensetzung, vorzugsweise durch Bestrahlung der durch Siebdruck aufgebrachten Schicht. Photohärtbare Harzzusammensetzungen, die durch Siebdruck aufgebracht werden können, sind dem Fachmann der Leiterplattenherstellung wohlbekannt.

Bei solchen photohärtbaren Harzen kann es sich beispielsweise um Harze handeln, die polymerisierbare Acrylat- oder Methacrylatestergruppen enthalten und die zusammen mit radikalerzeugenden Photoinitiatoren für besagte Gruppen eingesetzt werden; es kann sich auch um Epoxidharze handeln, die zusammen mit kationischen Photoinitiatoren für die Härtung besagter Harze, beispielsweise zusammen mit Oniumsalzen, eingesetzt werden; ferner kann es sich um Harze handeln, die direkt aktivierbare strahlungsempfindliche Gruppen, wie beispielsweise Cinnamat-, Chalkon-, Phenylpentadienongruppen oder ähnliche Reste, enthalten.

Schritt iv) wird vorzugsweise durchgeführt, indem man

a) eine Schicht eines Photoresists über dem galvanisch abgeschiedenen Film aufbringt,

b) die Schicht des Photoresists in einem vorbestimmten Muster bestrahlt, wobei die Differenzierung der Löslichkeit zwischen bestrahlten und unbestrahlten Teilen der Schicht bewirkt wird, und

c) die löslicheren Teile der bestrahlten Schicht durch Behandlung mit einem Lösungsmittel entfernt.

In Schritt iv) (a) wird der Photoresist in der Regel auf die gesamte Substratoberfläche aufgebracht, also über die in Schritt iii) weggeätzten Flächen und über den galvanisch abgeschiedenen Film.

Es eignen sich positiv- und negativ-arbeitende Photolacke. Dies können flüssige, polymerisierbare Photoresists oder feste Photoresists sein, die als vorgeformte Filme, als Pulver, die durch Aufschmelzen in flüssige Schichten übergeführt werden und beim Abkühlen Filme bilden, oder als Lösungen in Lösungsmitteln, die durch Verdampfen des Lösungsmittels den Photoresistfilm bilden, auf das Substrat aufgebracht werden können.

Die negativ-arbeitenden Photoresists für Schritt iv) (a) umfassen die wohlbekannten photohärtbaren Harzmischungen, wie Gemische enthaltend Harze mit direkt aktivierbaren, strahlungsempfindlichen Gruppen, beispielsweise Harze enthaltend Azido-, Coumarin-, Stilben-, Maleinimid-, Pyridinon- oder Anthracenreste, oder vorzugsweise Harze enthaltend $\alpha,\beta$-ethylenisch ungesättigte Ester- oder Ketongruppen mit einer aromatischen oder ethylenisch ungesättigten Gruppe in Konjugation mit besagter $\alpha$-,$\beta$-ethylenisch ungesättigten Gruppe, wie beispielsweise Cinnamat-, Sorbat-, Chalkon-, phenylsubstituierte Propenon- oder phenylsubstituierte Pentadienongruppen. Harze enthaltend solche strahlungsempfindliche Gruppen sind beispielsweise aus der US-A-4,572,890 bekannt.

Weitere zur Anwendung in Schritt iv) (a) geeignete photohärtbare Harzmischungen umfassen Zusammensetzungen enthaltend ein kationisch polymerisierbares Material, insbesondere ein Epoxidharz oder einen Vinylether, in Kombination mit einem kationischen Photoinitiator für besagtes Material, insbesondere einem Metalloceniumsalz, einem Oniumsalz oder einem aromatischen Iodosylsalz. Strahlungshärtbare Zusammensetzungen dieses Typs sind beispielsweise bekannt aus der US-A-4,572,890 und aus der EP-A-94,915.

Weitere zur Anwendung als Photoresist in Schritt iv) (a) geeignete Harzmischungen umfassen Zusammensetzungen enthaltend ein radikalischpolymerisierbares, ungesättigtes Material, bevorzugt ein Acrylat oder ein Methacrylat, in Kombination mit einem freie Radikale erzeugenden Photoinitiator für besagtes Material.

Viele solcher strahlungshärtbaren Acrylatmaterialien, also von acrylat- oder methacrylatgruppenhaltigen Materialien, sind kommerziell erhältlich. Weitere zur Anwendung in Schritt iv) (a) geeignete negativarbeitende Photoresists umfassen Substanzen oder Substanzgemische, die eine Acrylat-oder Methacrylatgruppe und eine direkt aktivierbare, strahlungsempfindliche Gruppe, beispielsweise eine der weiter oben beschriebenen Gruppen, enthalten und die in Kombination mit einem freie Radikale erzeugenden Photoinitiator für besagte Acrylat- oder Methacrylatgruppe eingesetzt werden. Solche Photoresists sind beispielsweise in den US-A-4,413,052 und -4,416,975 und in der EP-A-207,893 beschrieben.

Zur Anwendung in Schritt iv) (a) geeignete positiv-arbeitende Photolacke umfassen Polymere auf Basis von Polyoxymethylen, die beispielsweise aus der US-A-3,991,033 bekannt sind; oder o-Nitrocarbinolester, die beispielsweise aus der US-A-3,849,137 bekannt sind; oder o-Nitrophenylacetale, deren Polyester und endgruppen-verkappte Derivate, die beispielsweise aus der US-A-4,086,210 bekannt sind; oder Sulfonatester von aromatischen Alkoholen, die in $\alpha$- oder $\beta$-Stellung zur Sulfonatestergruppe eine Carbonylgruppe aufweisen; oder N-Sulfonyloxiderivate von aromatischen Amiden oder Imiden, wie beispielsweise die aus der US-A-4,618,564 bekannten Ester oder Imide; oder aromatische Oximsulfonate, wie in der EP-A-199,672 beschrieben; oder Chinondiazide, wie beispielsweise chinondiazid-modifizierte Phenolharze; oder Harze, die Benzoingruppen in der Kette enthalten, wie besipielsweise in der US-A-4,368,253 beschrieben.

Die Photoresists können übliche Photosensibilisatoren enthalten und weitere nicht photoempfindliche, filmbildende Polymere, wie sie üblicherweise in konventionellen Photoresists eingesetzt werden.

Vorzugsweise setzt man in Schritt iv) (a) negativarbeitende Photolacke ein, besonders bevorzugt verwendet man solche Resists, die sich als Lötstoppmasken eignen.

Die Bestrahlung der Photolackschicht in einem vorbestimmten Muster in Schritt iv) (b) kann durch Bestrahlung durch ein bildtragendes Dia erfolgen, das aus im wesentlichen undurchlässigen und aus im wesentlichen durchlässigen Flächenanteilen besteht. Die Bestrahlung kann auch vermittels eines computergesteuerten Laserstrahls erfolgen.

In der Regel verwendet man elektromagnetische Strahlung im Wellenlängenbereich von 200-600 nm. Geeignete Strahlungsquellen umfassen Kohlelichtbögen, Quecksilberdampflampen, Leuchtstoffröhren mit UV-Licht emittierenden Leuchtstoffen, Argon- und Xenon-Glimmlampen, Wolframlampen oder photographische Flutlichtlampen.

Bevorzugt werden Quecksilberdampflampen und Metallhalogenidlampen. Die notwendige Belichtungszeit hängt von mehreren Faktoren ab, beispielsweise von der Natur und der Dicke der Komponenten der Photoresistschicht, der Art der Strahlungsquelle und deren Abstand von der Lötstoppmaske. Die fallweise notwendigen Belichtungszeiten können anhand von Routinetests ermittelt werden.

Die Entfernung der löslicheren Flächen der bestrahlten Schicht in Schritt iv) (c) wird üblicherweise durch Behandlung mit einem Lösungsmittel durchgeführt. Dieses wird der Natur des Photoresists entsprechend ausgewählt. Es kann sich dabei um Wasser handeln, um eine wässrige oder wässrig-organische Lösung einer Säure oder Base oder um ein organisches Lösungsmittel oder um Gemische solcher Lösungsmittel. Geeignete saure Lösungen enthalten beispielsweise Essigsäure, Milchsäure, Glykolsäure oder Toluol-p-sulfonsäuren; geeignete basische Lösungen enthalten beispielsweise Natrium- oder Kaliumhydroxid oder -carbonat.

Geeignete organische Lösungsmittel umfassen Kohlenwasserstoffe, wie Toluol und Xylol; halogenierte Kohlenwasserstoffe, wie 1,1,1-Trichlorethan und Dichlormethan; hydroxylgruppenhaltige Lösungsmittel, wie Ethanol, 2-n-Butoxyethanol und 2-Ethoxyethanol; Ester, wie 2-Ethoxyethylacetat; Ketone, wie Cyclohexanon, Aceton und Methylethylketon; und Ether, wie Tetrahydrofuran.

Handelt es sich bei dem in Schritt iv) (a) eingesetzten Photolack um einen negativ-arbeitenden Photolack, so werden die in Schritt iv) (b) nicht bestrahlten Flächenanteile durch die Lösungsmittelbehandlung in Schritt iv) (c) entfernt. Handelt es sich bei dem in Schritt iv) (a) eingesetzten Photolack um einen positiv-arbeitenden Photolack, so werden üblicherweise die in Schritt iv) (b) bestrahlten Flächenanteile durch die Lösungsmittelbehandlung in Schritt iv) (c) entfernt, es sei denn, dass ein Bildumkehrprozess verwendet wird, beispielsweise mit einem Photolack auf Chinondiazidbasis, wodurch die Löslichkeit der ursprünglich der Strahlung ausgesetzten Flächenanteile in einem Folgeschritt gegenüber den anderen Flächenanteilen verringert wird, so dass dadurch die in Schritt iv) (b) nicht bestrahlten Flächenanteile in Schritt iv) (c) entfernt werden.

Das zur Entfernung der unbedeckten Flächenanteile des galvanisch abgeschiedenen Films in Schritt v) verwendete Lösungsmittel kann aus derselben Gruppe von Lösungsmitteln ausgewählt werden, wie bereits weiter oben zur Entfernung des Photoresists in Schritt iv) (c) beschrieben.

Die Entfernung des galvanisch abgeschiedenen Films kann in einem von Schritt iv) (c) separaten Schritt durchgeführt werden, wobei beispielsweise ein anderes als in Schritt iv) (c) verwendetes Lösungsmittel verwendet wird.

In einer bevorzugten Ausführungsform des erfindungsgemässen Verfahrens wird das Entfernen des galvanisch abgeschiedenen Films v) durch die Lösungsmittelbehandlung in Schritt iv) (c) bewerkstelligt.

Geeignete Lösungsmittel lassen sich durch Routinetests ermitteln.

In einer besonders bevorzugten Ausführungsform des erfindungsgemässen Verfahrens, worin der erste Resist durch ein wässriges Lösungsmittel entfernt wird, entfernt man den zweiten Resist mit einem organischen Lösungsmittel und der galvanisch abgeschiedene Film wird durch das organische Lösungsmittel entfernt, das zum Entfernen des zweiten Resists verwendet wird.

Das erfindungsgemässe Verfahren lässt sich besonders zur Herstellung von gedruckten Mehrlagenschaltungen anwenden, insbesondere zur Herstellung von Mehrlagenschaltungen, die galvanisch überzogene durchgehende Bohrungen oder Durchgänge aufweisen.

Die folgenden Beispiele erläutern die Erfindung. Darin bedeuten Teile und Prozente Gewichtsteile bzw. -prozente, sofern nichts anderes angegeben ist. Die in den folgenden Beispielen verwendeten Harze stellt man folgendermassen her:

Harz 1:

Eine Monomermischung aus 47,5 Teilen Styrol, 25 Teilen 2-Ethylhexylacrylat, 20 Teilen 2-Hydroxyethylmethacrylat und 7,5 Teilen Dimethylaminoethylmethacrylat enthaltend 1,5 Teile Azo-bis-(isobutyronitril) wird tropfenweise im Verlaufe von zwei Stunden zu 50 Teilen 2-n-Butoxyethanol gegeben, wobei unter Stickstoff bei 100°C gerührt wird. Die Reaktionsmischung wird eine weitere Stunde bei 100°C gehalten und eine weitere Menge von 0,5 Teilen Azo-bis-(isobutyronitril) in 2-n-Butoxyethanol wird zugefügt. Dieser Vorgang wird noch zweimal wiederholt und die Reaktionsmischung wird eine weitere Stunde bei 100°C gehalten und anschliessend abgekühlt. Der Aminwert der resultierenden Lösung beträgt 0,28 Aequ./kg und das Molekulargewicht des Copolymeren ist 10416.

Harz II

Eine Monomermischung aus 60 Teilen Styrol, 27,5 Teilen 2-Ethylhexylacrylat, 7,5 Teilen 2-Hydroxyethylmethacrylat und 5 Teilen 2-(Dimethylamino)-ethylmethacrylat enthaltend 1,5 Teile Azo-bis-(isobutyronitril) wird tropfenweise im Verlaufe von zwei Stunden zu 50 Teilen 2-n-Butoxyethanol gegeben, wobei bei 120°C gerührt wird.

Die Reaktionsmischung wird eine weitere Stunde bei 120°C gehalten und eine weitere Menge von 0,5 Teilen Azo-bis-(isobutyronitril) und 5,5 Teilen 2-n-Butoxyethanol wird zugegeben. Dieser Vorgang wird noch zweimal wiederholt und die Reaktionsmischung wird noch eine weitere Stunde bei 120°C gehalten und anschliessend abgekühlt. Der Aminwert der resultierenden Lösung beträgt 0,19 Aequ./kg und das Molekulargewicht des Copolymeren ist 10279.

Harz III

Eine Monomermischung aus 20 Teilen Methylmethacrylat, 22,5 Teilen n-Butylacrylat, 5 Teilen 2-Hydroxyethylmethacrylat und 2,5 Teilen Methacrylsäure enthaltend 0,015 Teile 1-tert.-Dodecylmercaptan und 0,75 Teile Azo-bis-(isobutyronitril) wird tropfenweise im Verlaufe von zwei Stunden bei 100°C unter Rühren zu 50 Teilen 2-n-Butoxyethanol gegeben. Die Reaktionsmischung wird eine weitere Stunde bei 100°C gehalten und eine weitere Menge von 0,25 Teilen Azo-bis-(isobutyronitril) wird zugegeben. Die Mischung wird weitere drei Stunden lang bei 100°C gehalten und dann 30 Minuten lang unter reduziertem Druck eingedampft, um vor dem Abkühlen flüchtige Bestandteile zu entfernen. Der Säurewert der erhaltenen Lösung beträgt 0,30 Aequ./kg und das Molekulargewicht des Copolymeren ist 10048.

Harz IV

Man erhitzt 100 Teile eines Epoxidharzes, das durch Vorverlängerung eines Diglycidylethers von Bisphenol A mit Bisphenol A erhalten wurde (Epoxidgehalt: 1,55 Mol/kg), mit 47,3 Teilen 2-n-Butoxyethanol auf 140°C, so dass sich eine Lösung bildet. Dazu gibt man 16,7 Teile Diethanolamin und hält die Mischung bei 140°C, bis der Epoxidgehalt null ist. Die Lösung wird auf 70°C abgekühlt und man fügt 9,6 Teile wässrige 75 %ige Milchsäure und anschliessend 15,7 Teile Wasser zu. Danach kühlt man die Harzlösung ab.

Harz V

Dabei handelt es sich um ein flüssiges Epoxidharz auf Bisphenol A Basis mit einem Epoxidgehalt von 5,3 Mol/kg.

Harz VI

Dabei handelt es sich um 3,4-Epoxycyclohexylmethyl-3',4'-epoxycyclohexancarboxylat.
Bei den RISTON® und VACREL® Photolacken handelt es sich um Photolacke auf Acrylatbasis. Die Produkte sowie der VACREL® Entwickler sind kommerziell erhältlich von DuPont (UK) Ltd., Riston Division, Wedgwood Way, Stevenage, Hertfordshire SG1 4QN, England. Die wässrige Lösung des "Robertsons Aqueous Film Stripper 279 H", welche in den Beispielen verwendet wird, ist erhältlich durch Verdünnen der 70 %igen wässrigen Lösung von Ethanolamin mit Wasser. Diese Lösung ist erhältlich von Robertsons Chemicals Ltd., Shepherds Grove Industrial Estate West, Stanton, Bury St. Edmunds, Suffolk IP31 2AR, England.

Beispiel 1:

Ein kupferkaschiertes Laminat wird mit einem wässrig entwickelbaren RISTON® Negativ-Photolack beschichtet. Dieser Lack wird bildmässig belichtet und entwickelt, so dass ein negatives Muster in besagtem RISTON® Photolack entsteht. Das Laminat wird als Kathode in einem Galvanisierbad geschaltet, welches mit einer Anode aus rostfreiem Stahl ausgerüstet ist. Das Galvanisierbad enthält die folgende Lösung:
100 Teile Harz I,
6,7 Teile 20 %ige wässrige Milchsäure,
493,3 Teile Wasser.
Es wird zwei Minuten lang eine Spannung von 2 V angelegt und anschliessend vier Minuten lang eine Spannung von 5 V.
Das Laminat wird dann aus dem Bad entfernt, mit Wasser gespült und fünf Minuten lang bei 110°C getrocknet. Das galvanisch abgeschiedene Harz füllt die Flächen aus, an denen sich kein Photolack befindet und das Kupfer freiliegt. Das Laminat wird dann bei 50°C in ein Bad von "CANNING 1887 DRY FILM STRIPPER" getaucht (erhältlich von W. Canning Materials Ltd., Birmingham, B18 6AS).

Durch diese Behandlung wird der Photolack entfernt und der galvanisch abgeschiedene Film bleibt zurück. Das freigelegte Kupfer wird durch Behandlung mit einem ammoniakhaltigen Kupfer-II-chloridbad weggeätzt. Danach wird die Platte mit Wasser gewaschen und getrocknet. Man erhält auf dem Basislaminat ein klares Muster aus Kupfer, das mit dem galvanisch abgeschiedenen Harzfilm bedeckt ist. Eine Lötstoppmaske aus einem VACREL® Photolack wird mit einem Trockenlaminator auf der Oberfläche enthaltend das Kupfermuster aufgebracht. Der Film der Lötstoppmaske wird 90 Sekunden lang durch ein bildtragendes Dia bestrahlt, wobei man eine Lampe verwendet, die Strahlung im Bereich von 350-450 nm emittiert. Das Laminat wird in einen käuflichen VACREL® Entwickler eingetaucht und die bei der bildmässigen Belichtung nicht bestrahlten Teile der Lötstoppmaske werden entfernt. Ferner wird der galvanisch abgeschiedene Film in diesen Teilen entfernt, so dass Lötmittel jetzt an das freigelegte Kupfer herantreten kann.

In den bestrahlten Flächenanteilen wird der galvanisch abgeschiedene Film nicht angegriffen und stellt somit eine gute Verbindung zwischen den Kupferbahnen und der Lötstoppmaske her.

Beispiel 2:

Ein kupferkaschiertes Laminat wird mit einem wässrig entwickelbaren RISTON® Negativ-Photolack beschichtet. Dieser Lack wird bildmässig belichtet und entwickelt, so dass ein negatives Muster in dem Photolack entsteht. Das Laminat wird als Kathode in einem Galvanisierbad geschaltet, welches mit einer Anode aus rostfreiem Stahl ausgerüstet ist. Das Galvanisierbad enthält folgende Lösung:
100 Teile Harz II,
6,7 Teile 20 %ige wässrige Milchsäure,
493,3 Teile Wasser.
Es wird eine Minute lang eine Spannung von 80 V angelegt. Danach wird das Laminat aus dem Bad entfernt, mit Wasser gespült und fünf Minuten lang bei 110°C getrocknet.
Der galvanisch abgeschiedene Harzfilm bedeckt die Flächen, worauf sich kein Photoresist befindet und das Kupfer freiliegt. Das Laminat wird dann bei 50°C in ein Bad aus einer 10 %igen wässrigen Lösung aus "ROBERTSONS 279 H DRY FILM STRIPPER" getaucht.
Durch diese Behandlung wird der Photoresist entfernt und der galvanisch abgeschiedene Film bleibt zurück. Das freigelegte Kupfer wird bei 50°C mit einer wässrigen Lösung von Schwefelsäure und Ammoniumpersulfat weggeätzt. Danach wird die Platte in Wasser gewaschen und getrocknet. Es bleibt ein klares Kupfermuster, welches mit dem galvanisch abgeschiedenen Film bedeckt ist, auf dem Basislaminat zurück.
Auf diese Oberfläche enthaltend das Kupfermuster wird ein zweiter RISTON® Photoresist mit Hilfe eines Trockenfilmlaminators aufgebracht. Der Photoresistfilm wird 15 Sekunden lang durch ein bildtragendes Dia mittels einer 5 kW Metallhalogenidlampe im Abstand von 75 cm bestrahlt. Das Laminat wird in eine Mischung aus 0,5 Teilen Natriumcarbonat, 4 Teilen 2-n-Butoxyethanol und 95,5 Teilen Wasser eingetaucht, um Flächen des Photoresists zu entfernen, die bei der bildmässigen Belichtung nicht bestrahlt wurden. Das dadurch freigelegte galvanisch abgeschiedene Harz wird durch Eintauchen in 1,1,1-Trichlorethanbad und leichtes Reiben entfernt. In den bestrahlten Flächenanteilen wird der galvanisch abgeschiedene Film nicht beeinflusst und stellt somit eine gute Verbindung zwischen den Kupferbahnen und dem Photoresist her.

Beispiel 3:

Ein kupferkaschiertes Laminat wird mit einem wässrig entwickelbaren RISTON® Negativ-Photolack beschichtet. Dieser Lack wird bildmässig belichtet und entwickelt, so dass ein Muster in dem Photolack entsteht. Das Laminat wird als Anode in einem Galvanisierbad geschaltet, welches mit einer Kathode aus rostfreiem Stahl ausgerüstet ist. Das Galvanisierbad enthält folgende Lösung:

100 Teile Harz III,
5 Teile 20 %ige wässriges Kaliumhydroxid,
395 Teile Wasser.

Es wird eine Minute lange eine Spannung von 40 V angelegt. Danach wird das Laminat aus dem Bad entfernt, mit Wasser gespült und fünf Minuten lang bei 110° C getrocknet.

Der galvanisch abgeschiedene Film bedeckt die Flächen, worauf sich kein Photoresist befindet und das Kupfer freiliegt. Das Laminat wird dann bei 50° C in ein Bad aus einer 10 %igen wässrigen Lösung aus "ROBERTSONS 279 H DRY FILM STRIPPER" getaucht. Durch diese Behandlung wird der Photoresist entfernt und der galvanisch abgeschiedene Film bleibt zurück. Das freigelegte Kupfer wird bei 50° C mit einer wässrigen Lösung von Schwefelsäure und Ammoniumpersulfat weggeätzt. Danach wird die Platte in Wasser gewaschen und getrocknet. Es bleibt ein klares Kupfermuster, welches mit dem galvanisch abgeschiedenen Film bedeckt ist, auf dem Basislaminat zurück. Auf diese Oberfläche enthaltend das Kupfermuster wird ein zweiter RISTON® Photoresistfilm mit Hilfe eines Trockenfilmlaminators aufgebracht. Der Photoresistfilm wird 15 Sekunden lang durch ein bildtragendes Dia mittels einer 5 kW Metallhalogenidlampe im Abstand von 75 cm bestrahlt. Das Laminat wird in 1,1,1-Trichlorethan eingetaucht, um Flächen des Photoresists, die bei der bildmässigen Belichtung nicht bestrahlt wurden, und das dadurch freigelegte galvanisch abgeschiedene Harz zu entfernen.

In den bestrahlten Flächenanteilen wird der galvanisch abgeschiedene Film nicht beeinflusst und stellt somit eine gute Verbindung zwischen den Kupferbahnen und dem Photoresist her.

Beispiel 4:

Beispiel 2 wird wiederholt, wobei eine Lösung von 100 Teilen Harz IV in 566,6 Teilen Wasser im Galvanisierbad anstelle der Lösung von Harz II verwendet wird. Man legt für zwei Sekunden eine Spannung von 80 V an (anstelle von einer Minute), und entfernt sowohl die unbestrahlten Flächenanteile des zweiten Photoresists als auch des galvanisch abgeschiedenen Harzes unter diesen Flächenanteilen durch Eintauchen in 1,1,1-Trichlorethan. In den bestrahlten Flächenanteilen wird der galvanisch abgeschiedene Film nicht angegriffen und stellt somit eine gute Verbindung zwischen den Kupferbahnen und dem zweiten Photoresist her.

Beispiel 5:

Ein kupferkaschiertes Laminat, welches mit einem RISTON® Photoresist beschichtet ist sowie bildmässig belichtet und entwickelt wurde, wobei sich ein Muster im Photolack ausbildet, wird als Kathode in einem Galvanisierbad geschaltet, das mit einer Anode aus rostfreiem Stahl ausgerüstet ist. Das Galvanisierbad enthält die folgende Lösung:

100 Teile Harz II,
6,7 Teile 20 %ige wässrige Milchsäure,
493,3 Teile Wasser.

Es wird eine Minute lang eine Spannung von 70 V angelegt. Danach wird das Laminat aus dem Bad entfernt, mit Wasser gespült und fünf Minuten lang bei 110° C getrocknet. Der galvanisch abgeschiedene Harzfilm bedeckt die Flächen, worauf sich kein Photoresist befindet und das Kupfer freiliegt. Das Laminat wird dann bei 50° C in ein Bad aus einer 10 %igen wässrigen Lösung aus "ROBERTSONS 279 H DRY FILM STRIPPER" getaucht. Durch diese Behandlung wird der Photoresist entfernt und der galvanisch abgeschiedene Film bleibt zurück. Das freigelegte Kupfer wird bei 50° C mit einer wässrigen Lösung von Schwefelsäure und Ammoniumpersulfat weggeätzt. Danach wird die Platte in Wasser gewaschen und getrocknet. Es bleibt ein klares Kupfermuster, welches mit dem galvanisch abgeschiedenen Film bedeckt ist, auf dem Basislaminat zurück. Auf diese Oberfläche enthaltend das Kupfermuster wird eine Schicht einer Lötstoppmaske auf Basis von Phenylpentadienon aufgebracht. Die Lötstoppmaske wird 2 Minuten lang durch ein bildtragendes Dia mittels einer 5 kW Metallhalogenidlampe im Abstand von 75 cm bestrahlt. Das Laminat wird in eine Mischung aus 50 Teilen Propylencarbonat, 20 Teilen γ-Butyrolacton und 30 Teilen Butyldigol (Monobutylether von Diethylglykol) eingetaucht, um Flächen des Photoresists, die bei der bildmässigen Belichtung nicht bestrahlt wurden, und das dadurch freigelegte galvanisch abgeschiedene Harz zu entfernen.

In den bestrahlten Flächenanteilen wird der galvanisch abgeschiedene Film nicht beeinflusst und stellt somit eine gute Verbindung zwischen den Kupferbahnen und der Lötstoppmaske her.

Beispiel 6

Ein kupferkaschiertes Laminat wird mit einem wässrig entwickelbaren RISTON® Photolack beschichtet, bildmässig belichtet, entwickelt, so dass ein Muster im Photolack entsteht, und als Kathode in einem Galvanisierbad geschaltet, das mit einer Anode aus rostfreiem Stahl ausgestattet ist. Das Galvaniserbad enthält die folgende Lösung:
100 Teile Harz II,
6,7 Teile 20 %ige wässrige Milchsäure,
493,3 Teile Wasser.

Es wird eine Minute lang eine Spannung von 70 V angelegt. Danach wird das Laminat aus dem Bad entfernt, mit Wasser gespült und fünf Minuten lang bei 110°C getrocknet. Der galvanisch abgeschiedene Harzfilm bedeckt die Flächen, worauf sich kein Photoresist befindet und das Kupfer freiliegt. Das Laminat wird dann bei 50°C in ein Bad aus einer 10 %igen wässrigen Lösung aus "ROBERTSONS 279 H DRY FILM STRIPPER" getaucht. Durch diese Behandlung wird der Photoresist entfernt und der galvanisch abgeschiedene Film bleibt zurück. Das freigelegte Kupfer wird bei 50°C mit einer wässrigen Lösung von Schwefelsäure und Ammoniumpersulfat weggeätzt. Danach wird die Platte in Wasser gewaschen und getrocknet. Es bleibt ein klares Kupfermuster, welches mit dem galvanisch abgeschiedenen Film bedeckt ist, auf dem Basislaminat zurück. Auf ausgewählte Flächen des Kupfers auf dem Basislaminat, welches mit dem galvanisch abgeschiedenen Film bedeckt ist, wird mittels Siebdruck eine Mischung aus einem Teil Harz V, einem Teil Harz VI und 0,1 Teilen Triphenylsulfonium-hexafluoroantimonat aufgebracht. Dies wird dann fünf Minuten lang einer Flutlicht bestrahlung durch eine 5 kW Metallhalogenidlampe im Abstand von 75 cm ausgesetzt, wobei die durch Siebdruck aufgebrachte Harzmischung von einer flüssigen in eine klebfreie Beschichtung übergeführt wird. Das freiliegende galvanisch abgeschiedene Harz wird durch Eintauchen in 1,1,1,-Trichlorethan entfernt.

In den Flächenanteilen, die durch das durch Siebdruck aufgebrachte Harz geschützt sind, wird das galvanisch abgeschiedene Harz nicht beeinflusst und stellt somit eine gute Verbindung zwischen den Kupferbahnen und der Siebdruck-Harzzusammensetzung her.

**Patentansprüche**

1. Verfahren zur Herstellung von metallischen Mustern auf einem Substrat, welches auf der Oberfläche in vorbestimmten Flächen freiliegendes Metall aufweist und in den restlichen Flächen mit einem ersten Resist bedecktes Metall aufweist, umfassend die Schritte

i) Schutz des freiliegenden Metalls durch galvanisches Abscheiden eines Harzfilms auf besagtem Metall,

ii) Entfernen des ersten Resists von besagten restlichen Flächen unter Verwendung eines Lösungsmittels, das den galvanisch abgeschiedenen Film nicht entfernt,

iii) Aetzen des in Schritt ii) freigelegten Metalls mit einem Aetzmittel, das besagten galvanisch abgeschiedenen Film nicht entfernt,

iv) Herstellen einer Schicht eines zweiten Resists in einem vorbestimmten Mu-ster über besagtem galvanisch abgeschie-denen Film, wobei Flächen des galvanisch abgeschiedenen Films von dem Resist nicht bedeckt werden, und

v) Entfernen der unbedeckten Teile besagten galvanisch abgeschiedenen Films durch Behandlung mit einem Lösungsmittel für besagten Film.

2. Verfahren gemäss Anspruch 1, worin der erste Resist ein Photoresist ist, der unter wässrigen Bedingungen in Schritt ii) entfernbar ist, und worin der galvanisch abgeschiedene Film durch Behandlung mit einem organischen Lösungsmittel in Schritt v) entfernbar ist.

3. Verfahren gemäss Ansprüchen 1 oder 2, worin der galvanisch abgeschiedene Film ein Acrylharz; ein Addukt eines Epoxidharzes mit einem Amin, einer Polycarbonsäure, einem Anhydrid einer Polycarbonsäure, einer Aminocarbonsäure, einer Mercaptocarbonsäure oder einer Aminosulfonsäure; ein Polyurethan; ein Polyester; oder ein Reaktionsprodukt eines Harzes enthaltend phenolische Hydroxylgruppen mit einem Aldehyd und einem Amin oder einer Amino- oder Mercaptocarbonsäure oder einer Aminosulfonsäure umfasst.

4. Verfahren gemäss Anspruch 3, worin der galvanisch abgeschiedene Film ein Copolymeres auf Basis wenigstens eines Monoacryle-sters und wenigstens eines Monoacrylmono-mers enthaltend eine Carboxyl- oder tertiäre Aminogruppe und gegebenenfalls eines weiteren Vinylmonomers umfasst, oder worin der galvanisch abgeschiedene Film ein Addukt eines gegebenenfalls vorverlängerten Diglycidylethers eines Bisphenols mit einem Monoamin umfasst.

5. Verfahren gemäss Ansprüchen 1, 2, 3 oder 4, worin der galvanisch abgeschiedene Film aus einer wässrigen Galvanisierlösung abgeschieden wird, die 2 bis 60 Gew.% des galvanisch abscheidbaren Harzes enthält.

6. Verfahren gemäss Ansprüchen 1, 2, 3, 4 oder 5, worin die galvanische Abscheidung bei einer Spannung von 2 bis 200 V durchgeführt wird.

7. Verfahren gemäss Ansprüchen 1, 2, 3, 4, 5 oder 6, worin die galvanische Abscheidung in zwei Stufen ausgeführt wird, wobei die erste Stufe bei niedriger Spannung und die zweite Stufe dann bei höherer Spannung durchgeführt wird.

8. Verfahren gemäss Ansprüchen 1, 2, 3, 4, 5, 6 oder 7, worin Schritt iv) ausgeführt wird, indem die härtbare Harzzusammensetzung direkt in einem vorbestimmten Muster vermittels Siebdruck aufgebracht wird und dann gehärtet wird.

9. Verfahren gemäss einem der Ansprüche 1 bis 7, worin Schritt iv) durchgeführt wird durch

a) Aufbringen einer Schicht eines Photo-resists über den galvanisch abgeschiede-nen Film,

b) Bestrahlen der Photoresistschicht in einem vorbestimmten Muster, wobei eine Differenzierung der Löslichkeit zwischen den bestrahlten und unbestrahlten Teilen der Schicht erfolgt, und

c) Entfernen der löslicheren Teile der bestrahlten Schicht durch Behandlung mit einem Lösungsmittel.

10. Verfahren gemäss Anspruch 9, worin der Photoresist ein Negativresist ist.

11. Verfahren gemäss Anspruch 9 oder 10, worin das Entfernen v) des galvanisch abgeschiedenen Films durch die Lösungsmittelbehandlung in Schritt iv) (c) erfolgt.

12. Verfahren gemäss Ansprüchen 1 bis 11, worin der erste Resist durch Behandlung mit wässrigen Lösungsmitteln entfernt wird, der zweite Resist durch Behandlung mit organischen Lösungsmittel entfernt wird und der galvanisch abgeschiedene Harzfilm durch Behandlung mit einem organischen Lösungsmittel entfernt wird, das zur Entfernung des zweiten Resists verwendet wird.

13. Verfahren gemäss Ansprüchen 1 bis 12, worin das metallische Muster eine gedruckte Schaltung ist und das Metall Kupfer ist.